Europäisches Patentamt

European Patent Office

Office européen des brevets

(11) Publication number: **0 353 942**
**A2**

# EUROPEAN PATENT APPLICATION

(21) Application number: **89307623.2**

(22) Date of filing: **27.07.89**

(51) Int. Cl.⁴: **G06F 5/06**

(30) Priority: **02.08.88 US 227159**

(43) Date of publication of application:
**07.02.90 Bulletin 90/06**

(84) Designated Contracting States:
**AT BE CH DE ES FR GB GR IT LI LU NL SE**

(71) Applicant: **ADVANCED MICRO DEVICES, INC.**
**901 Thompson Place P.O. Box 3453**
**Sunnyvale, CA 94088(US)**

(72) Inventor: **Wang, Yun-Che**
**1033 Crestview Drive,No. 10**
**Mt View California(US)**
Inventor: **Scott, Paul**
**4558 Park Cherry Place**
**San Jose California(US)**

(74) Representative: **Wright, Hugh Ronald et al**
**Brookes & Martin 52/54 High Holborn**
**London WC1V 6SE(GB)**

(54) A ripple-through FIFO memory.

(57) A data buffer for facilitating data communication between two asynchronous devices has at least two arrays of first-in, first-out ripple-through memory. Data from each input operation is stored into the arrays based upon a first logic function, and data for each output operation is output based upon a second logic function.

EP 0 353 942 A2

# A RIPPLE-THROUGH FIFO MEMORY

This invention relates generally to first-in, first-out (FIFO) memories and preferably to a data buffer provided by at least two ripple-through type FIFO memories connected in parallel.

## BACKGROUND OF THE INVENTION

First-in, first-out (FIFO) memories are versatile devices used in many digital applications as data buffers for allowing intersystem communication in the presence of short term mismatches between the systems' respective data rates. For example, when a central processing unit (CPU) is connected to communicate data with one or more input/output (I/O) devices, the I/O devices typically produce data in asynchronous bursts, but at an average rate that is slower than the capability of the CPU to accept the data. If the CPU is required to be diverted from its main tasks to handle data-ready interrupts from the I/O devices each time a unit of information is sent, its efficiency will be greatly reduced.

A FIFO memory provides an economical way to alleviate performance degradation due to the above-discussed speed mismatches by providing a buffer between the systems. For example, with a FIFO memory, data generated from an I/O device can be deposited in the FIFO memory, to be retrieved by the CPU at a more convenient time, so that the CPU and the I/O devices can operate with reduced interruptions from each other.

Two most commonly used FIFO memory architectures are RAM-based FIFOs and ripple-through FIFO memories.

A RAM-based FIFO memory comprises basically a random access memory, an input counter, and an output counter. The input counter increments sequentially at each data input operation and points to FIFO memory location wherein the next input data is to be deposited. The output counter increments sequentially at each data output operation and points to the FIFO memory location wherefrom the next output data is to be retrieved. Both counters wrap around from the highest address to the zero address. The output counter follows the input counter so that the region from the output counter to the input counter is contained data of the FIFO memory and its complementary region is logically vacant. When the output counter catches up with the input counter, the FIFO memory is empty and output requests are rejected. When the input counter catches up with the output counter, the FIFO memory is full and input requests are rejected. Thus, at each input or output operation, a comparison between the input and output counters must be made to determine before the operation can be performed.

The RAM-based FIFO memory is structurally simple. However, because of the above described comparison requirement before each operation, a RAM-based FIFO memory suffers from the limitation that an input operation cannot be performed simultaneously with an output operation.

A ripple-through FIFO memory simulates a queue operation. In the ripple-through FIFO memory architecture, data is input at one (the top) end of the FIFO memory. From there the data "sinks" towards the other (the bottom) end of the FIFO memory and settles at the lowest vacant location. The data continues to ripple down at each output operation until it is retrieved from the FIFO memory at the bottom.

Although a ripple-through FIFO memory does not have the above discussed comparison requirement of the RAM-based FIFO memory, it has other disadvantages. For example, the duration between the instant when data is input into the top of an empty FIFO memory and the instant when the data can be output from the bottom is generally referred to as the fall through time of the FIFO memory. The fall through time of a FIFO memory is usually an undesirable feature because it represents access delay of input data. Obviously, the fall through time is a function of the size of a FIFO memory.

We will describe FIFO memory buffer that facilitates data communication between two asynchronous data processing devices.

We will describe a ripple-through FIFO memory whereby input and output operations can be performed simultaneously.

We will also describe a ripple-through FIFO memory in which the fall through time is substantially reduced without having to reduce its storage capacity.

## SUMMARY OF THE INVENTION

The present invention is ripple-through FIFO memory buffer for facilitating data communication between two asynchronous devices. The FIFO memory buffer according to this invention comprises at least two arrays of ripple-through memory each having an input means and an output means. The FIFO memory buffer according to the present invention has an input control means coupled to each input means for controlling the input to each of the arrays using a first logic function and an output control means coupled each output means for controlling the output from each of the arrays using a second logic function.

In an embodiment of the present invention, the input control means sequentially selects, at each input operation, one of the arrays to store an input data in accordance with a predetermined order, and the output control means sequentially selects, at each output operation, output from one of the arrays in accordance with the same predetermined order. The advantage provided by this embodiment is a FIFO memory with substantially reduced fall through time.

BRIEF DESCRIPTION OF THE DRAWINGS

Fig. 1 is a block diagram of the FIFO memory wherein the present invention is embodied.

Fig. 2 illustrates the structure of a memory array in the FIFO memory in the embodiment of the present invention.

Fig. 3 is a schematic logic diagram of the first and second flags of a memory array in the embodiment of the present invention.

Fig. 4 is a timing diagram illustrating the operation of the flags during a write operation.

Fig. 5 is a schematic logic diagram of the last and second last flags of a memory array in the embodiment of the present invention.

Fig. 6 is a timing diagram illustrating the operation of the flags during a read operation.

Fig. 7 illustrates an embodiment of the present invention wherein fall-through time of a FIFO memory is reduced.

Fig. 8 is a schematic logic diagram of the input control means for selecting a memory array to store an input data in the embodiment of the present invention.

Fig. 9 is a schematic logic diagram of the output control means for selecting data from a memory array as the output of the FIFO memory in the embodiment of the present invention.

Fig. 10 illustrates an input interface for converting serial input data to parallel input data.

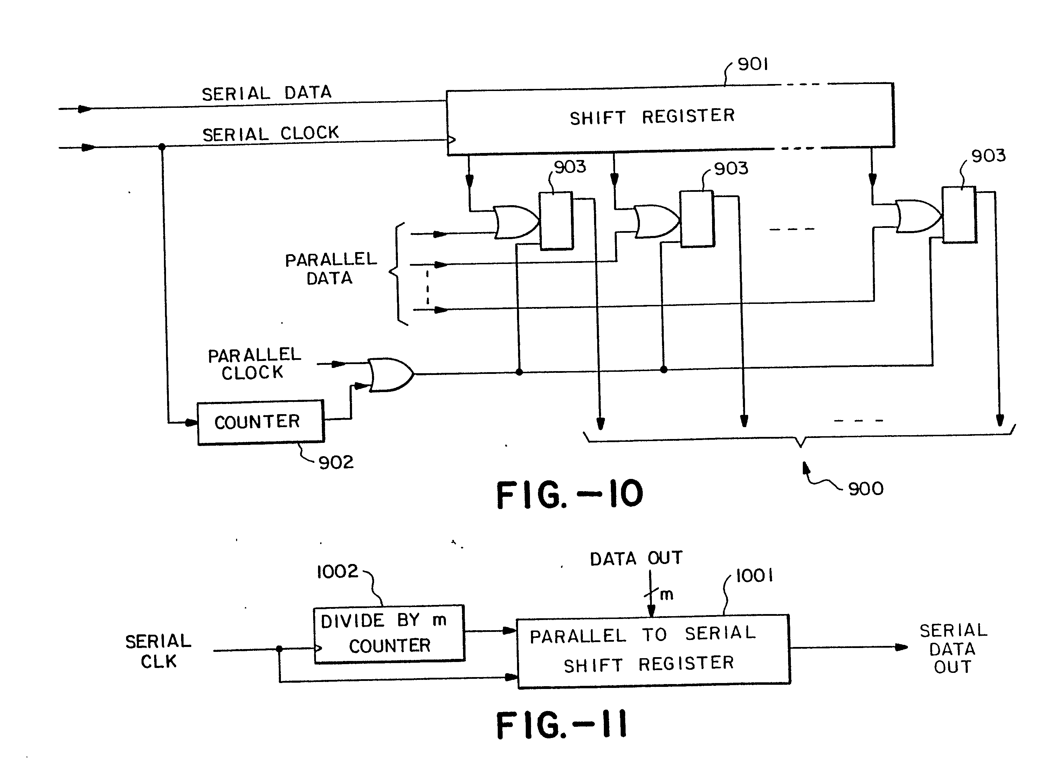

Fig. 11 illustrates an output interface for converting parallel output data to serial output data.

Fig. 12 illustrates a bus funnel wherein the present invention is embodied.

Fig. 13 illustrates a bus expander wherein the present invention is embodied.

DETAILED DESCRIPTION

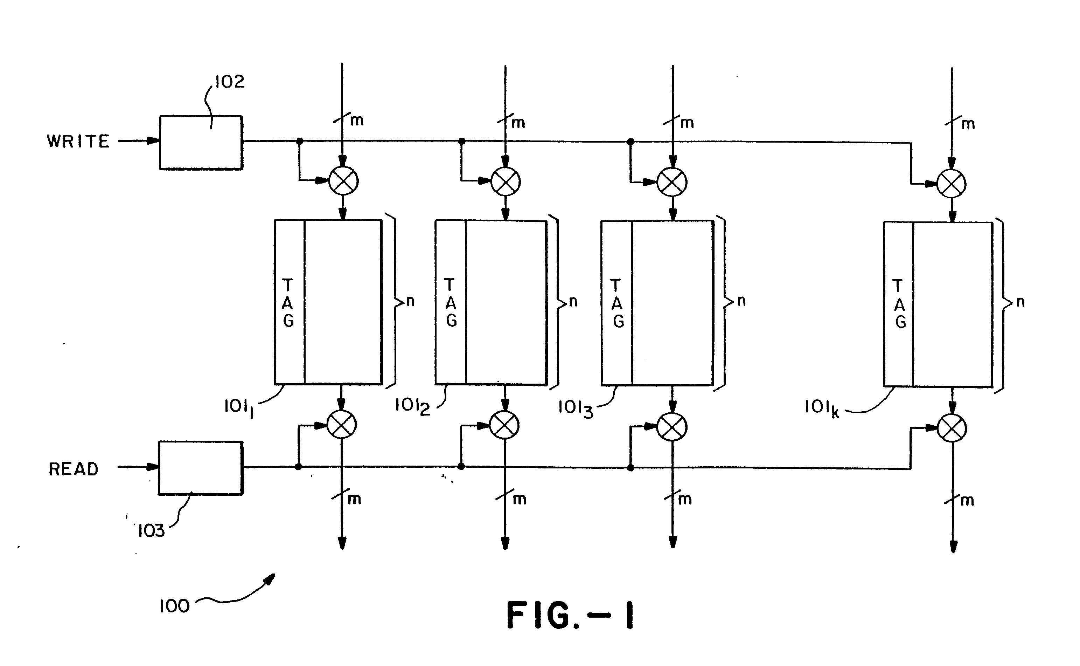

Fig. 1 is a block diagram of a FIFO memory 100 wherein the present invention is embodied. The FIFO memory 100 comprises a plurality, k, of ripple-through FIFO memory arrays, $101_1$, $101_2$, $101_3$,.... $101_k$ each. Each array has n rows each of which has m bits. The input to each of the FIFO memory arrays 101 is controlled by an input control means 102. The output of from each FIFO memory array 101 is controlled by an output control means 103.

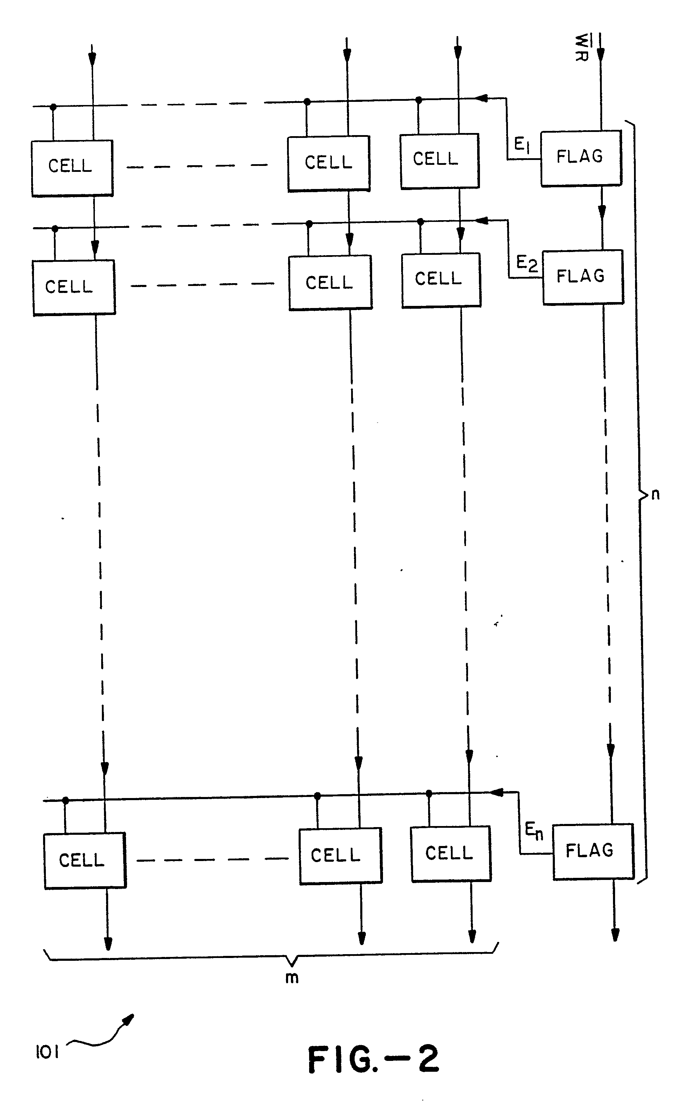

The structure of one of the memory arrays 101 is illustrated in Fig. 2. Each array 101 has n rows of memory cells. Each row has the same number of memory cells. In actual design, a register or data latches with parallel input can be used to implement a row of memory cells. Data input into a row of cells is controlled by a corresponding flag which provides an enable signal for writing data into the cells.

Data is input into the top row of an array. When data is written into the top row of an array, it "sinks" towards the bottom and settles into the lowest vacant row.

When data is output from the array, a vacancy is created at the bottom row. The vacancy then "floats" upward. Alternatively stated, when a vacancy is created in an array by an output operation, the data in the upper rows of the array will "sink" to their respective next lower rows. The movement of data within an array is controlled by the flags.

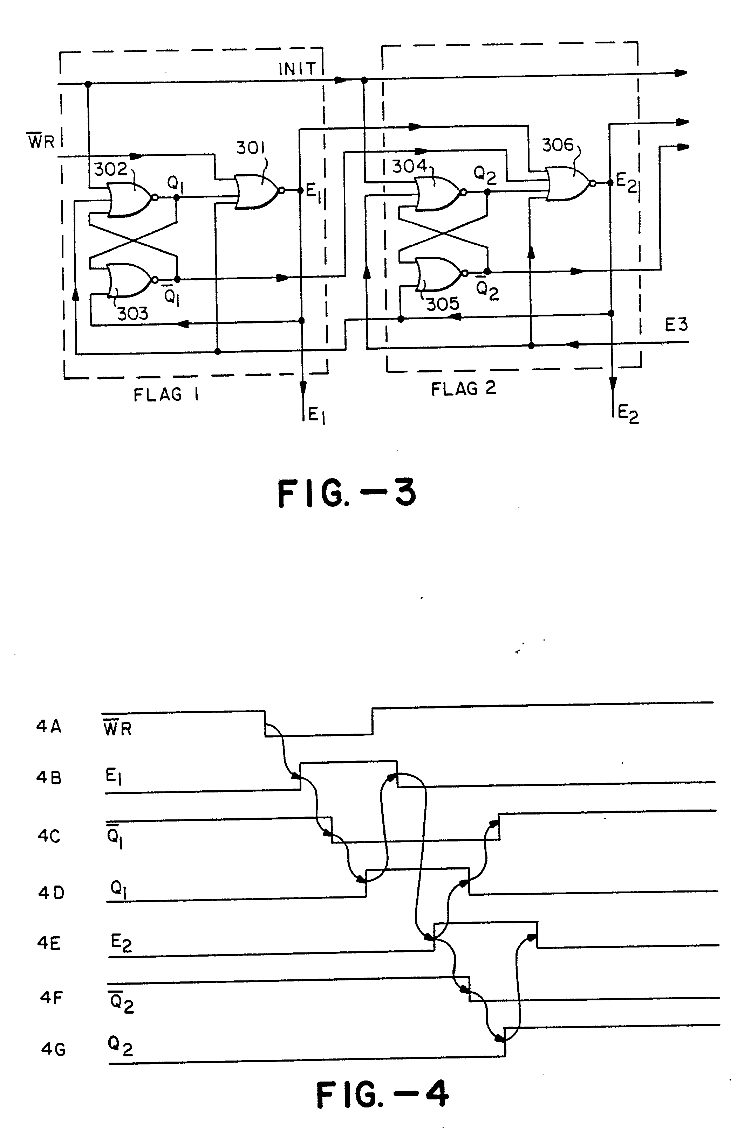

A preferred implementation of the flags is illustrated in Fig. 3. The figure shows the first and second flags of a memory array. Each flag comprises, in the preferred implementation, three NOR-gates connected at shown.

The operation of the flags is now described with reference to Fig. 4. The logic state of a flag, i, is represented by its output $Q_i$. When the FIFO memory is initialized, (e.g.) at power on, a "high" initialization signal INIT will be applied to gate 302, 304,....of each flag. The "high" initialization signal INIT causes output $Q_i$ of each flag, i, to become "low". At initialization, the write signal $\overline{WR}$ is "high", which in turn will cause the output $E_1$ of gate 301 to become "low". When both $Q_1$ and $E_1$ are "low", the output $\overline{Q_1}$ of gate 303 will become "high", a "high" level $\overline{Q_1}$ will cause the output $E_2$ of gate 306 to become "low". The initialization signal INIT also causes the output $Q_2$ of gate 304 to become "low". When both $Q_2$ and $E_2$ are "low", the output $\overline{Q_2}$ of 305 will become "high", and so on. Thus, at initialization, each flag, i, is reset and will have a "low" level output $Q_i$ and a "high" level complement output $\overline{Q_i}$.

Assume that the top two rows of the memory array are vacant. At each input operation, a "low" $\overline{WR}$ signal, as illustrated in Fig. 4a, will appear at gate 301. Because both $Q_1$ and $E_2$ are "low", the

output $E_1$ of gate 301 will become "high", as illustrated in Fig. 4b, once $\overline{WR}$ goes "low". A "high" level at the output $E_1$ of gate 301 will change the output $\overline{Q_1}$ of gate 303 to "low", as illustrated in Fig. 4c. The initialization signal INIT is "low" during normal operation of the FIFO memory. When $E_2$ is "low", a "low" $\overline{Q_1}$ will change output $Q_1$ of gate 302 from "low" to "high", as illustrated in Fig. 4d. When $Q_1$ becomes "high", the output $E_1$ of gate 301 will go to "low". With a "low" at each of $E_1$, $\overline{Q_1}$ and $Q_2$, the output $E_2$ of gate 306 will become "high", as shown in Fig. 4e. When $E_2$ goes to a "high", it forces the output $Q_1$ of gate 302 to "low". A "high" $E_2$ also changes the output $\overline{Q_2}$ of gate 305 to "low", as illustrated in Fig. 4f. It can be seen from Figs. 4b4d that the output $E$, of a flag, i, once set, will be reset after three gate delays. Therefore when the output $\overline{Q_2}$ of gate 305 drops, the output $Q_2$ of gate 304 will go to "high". Accordingly when a write signal $\overline{WR}$ appears at the first flag, a "high" signal will ripple through the flags.

The signal $E_i$ of each flag i is used to enable the storage of data into the corresponding $i^{th}$ row of memory cells.

Assume that when the write signal $\overline{WR}$ appears, the second row is already occupied, so that $Q_2$ of FLAG 2 is "high". A "high" $Q_2$ at the input of 306 causes a "low" at $E_2$, regardless of the level $E$. As a result, the transition of $E_2$ as shown in Fig. 4E will not occur, and $Q_1$ will stay at a "high" level. Therefore, when a write signal $\overline{WR}$ is applied to the flags, it will ripple from the top and stop at the lowest vacant position which in this case is the second row.

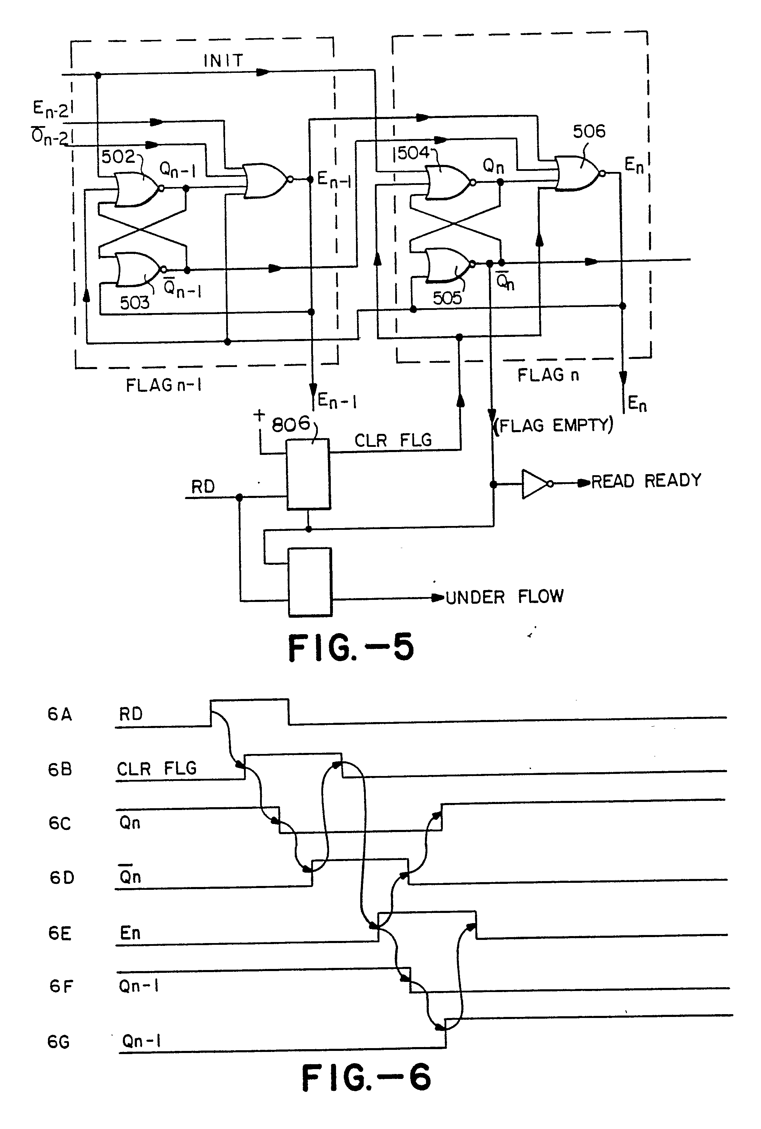

Fig. 5 illustrates the flags of the last two rows of an array. Gate 506 of the last flag, FLAG n, has an input connected to a latch 806. The data input of latch 806 is tied to a logical "high". The clock input of latch 806 is connected to receive a read signal RD, which goes from "low" to "high" at each read operation.

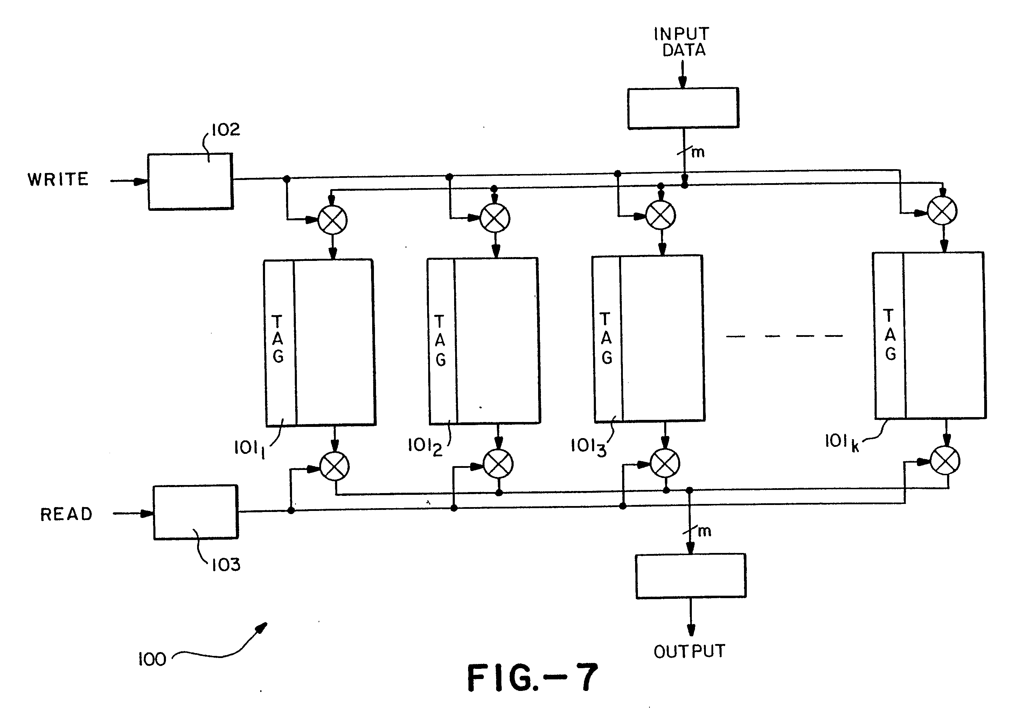

Assume that the bottom two rows of the array are occupied with data so that both $Q_n$ of FLAG n and $Q_{n1}$ of FLAG n1 are "high", and $\overline{Q_n}$ and $\overline{Q_{n-1}}$ are "low". With reference to the timing diagrams of Fig. 6, when data is read from (the bottom row) the array, a read signal RD, as illustrated in Fig. 6a, will clock the latch 806. Because the data input of latch 806 is tied to a "high", the read signal RD will cause signal CLRFLG to go from "low" to "high", as illustrated in Fig. 6b. A "high" CLRFLG signal at gate 504 causes the output $Q_n$ of gate 504 to go to a "low", as illustrated in Fig. 6c.

The "high" CLRFLG signal also causes $E_n$ to go "low". Thus a "low" $Q_n$ signal will cause $\overline{Qn}$ to go "high". When $\overline{Q_{n-1}}$ goes to "high", it resets latch 806 and drops the CLRFLG signal. Since $E_i$ for i =

1 on is always "low", as discussed previously, and $Q_{n-1}$ is "high", when CLRFLG drops, all inputs to gate 506 become "low" and the output $E_n$ of gate 506 will become "high", as illustrated in Fig. 6e. When $E_n$ becomes "high", it causes the output $Q_{n-1}$ of gate 502 to go to "low". Moreover, a "high" $E_n$ signal will cause the output $\overline{Q_n}$ at gate 505 to become "low", which in turn will cause $Q_n$ to go "high". As a result, FLAG n-1 will be reset, while FLAG n, after being reset, will again be set to a "high" level.

If only the bottom row of the array is occupied, $Q_{n-1}$ will be "low" and $\overline{Q_{n-1}}$ will be "high". In this case, a "high" to "low" transition at CLRFLG will not cause output $E_n$ at gate 506 to go from "low" to "high".

The $\overline{Q_n}$ is also used as a "flag empty" signal to clear latch 806. If the bottom row of an array is empty, the "flag empty" ($\overline{Q_n}$) will be high, so that latch 806 will not be set even with the activation of the read signal RD. When a read operation is issued to an empty array, the "flag empty" will be clocked by the read signal RD to generate an "underflow" signal.

In summary, when data is read from the bottom row of an array, a vacancy is created. This vacancy then floats upward to the top. In other words, when data is taken out from the bottom row of the array, the data from all the upper rows will fall down to their respective next lower rows.

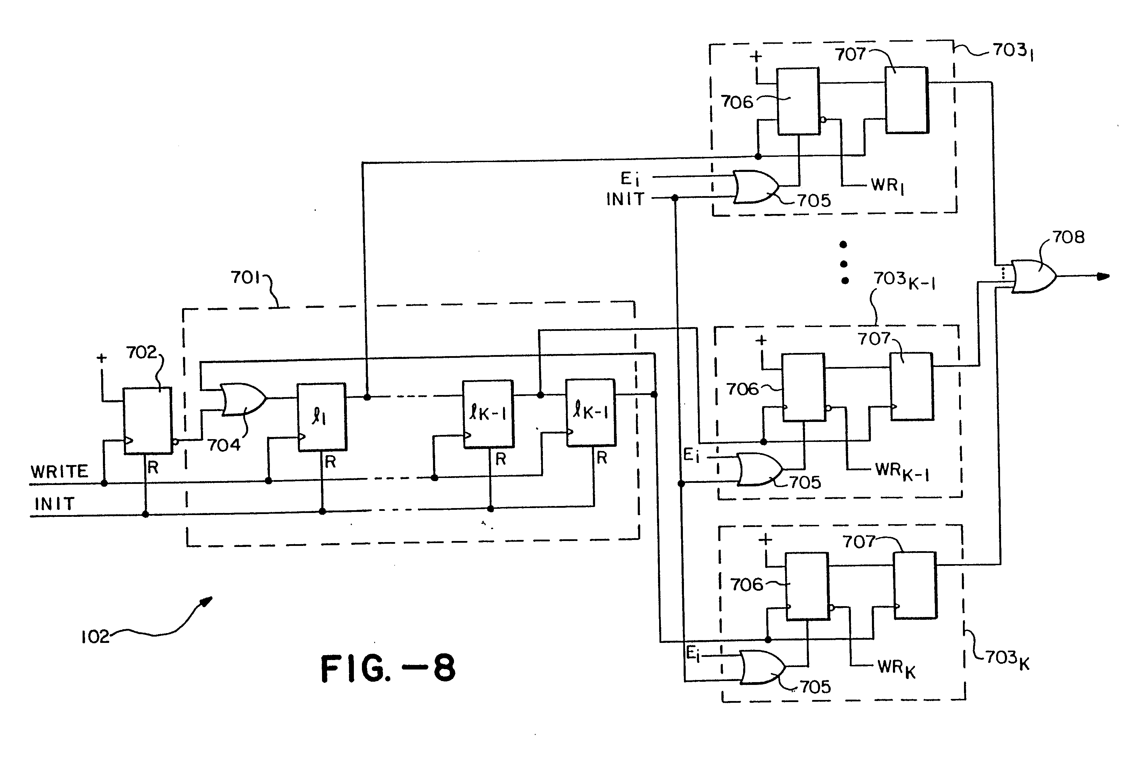

Fig. 7 is diagram which illustrates a first embodiment of the present invention. In Fig. 7, the inputs of the FIFO memory arrays 101 are coupled together to receive common data input. An input control means 102 is provided to sequentially select in a predetermined order, one of the arrays to store data of each of successive input operations. The respective output of the memory arrays 101 are coupled together to a common output. An output control means 103 is provided to sequentially selects data from one of the arrays as output the the FIFO memory 100 for each of successive output operations. The arrays are selected in the same predetermined order as an input operation.

In Fig. 8 is shown an input control means 102 for sequentially selecting, at each input operation, one of the k arrays to store an input data. The input control means 102 comprises a state machine 701 that generates k select signals, and k selector drivers 703 each of which receives a different select signal from the state machine 701 to enable input data into one of the k memory arrays.

According to the first embodiment, the state machine 701 is implemented with a ring counter having k latches, with each latch being clocked at each input operation.

With reference to Fig. 8, the latches $L_1...L_k$ is reset by the initialization signal INIT along with latch 702. After initialization, the negative output of latch 702 will be "high", which in turn causes a "high" at the output of gate 704. In a write operation, the output of gate 704 is clocked into latch L1. Because the input of gate 702 is tied "high" signal, the first write signal will also gate a "high" into latch 702, so that its negative output will return to "low" level.

At each write operation, one of the latches in 701 will be "high". The "high" level of this latch clocks the latch 706 in one of the select drivers 703 and loads a "high" into the latch. The respective negative output of latches 706 of the select drivers are used as the $\overline{WR}$ signal that go into the first flags of the memory arrays, as previously discussed.

If the top row of an array is already occupied, $Q_1$ is "high", so that even if $\overline{WR}$ goes from "high" to "low", $E_1$ will remain "low".

Latch 706 is reset by either the initialization signal INIT or the output $E_1$ of the first flag of an array. If the top row is not occupied, the "low"-"high"-"low" transition of $E_1$ will reset latch 706 at each input operation.

When the top row is occupied, the $E_1$ signal will remain "low" even when when $\overline{WR}$ is active, and latch 706 will not be reset. At the next input operation, the "high" level of latch 706 will be clocked into latch 707, causing its output to become "high". The output of latch 707 is used to generate an "overflow" signal at the output of gate 708.

The input control means 102 thus sequentially selects one of the arrays 101 to store data of each of successive input operations in a predetermined order. As one example, assume k is equal to 3, one such predetermined order may be array 1, array 2, array 3, array 1, array 2, ... More specifically, data from a first input operation will be written into array 1, data from the next input operation will be written into array 2, then array 3, then array 1, and so on. As another example, the predetermined order may be array 2, array 3, array 1, array 2, array 3 ...

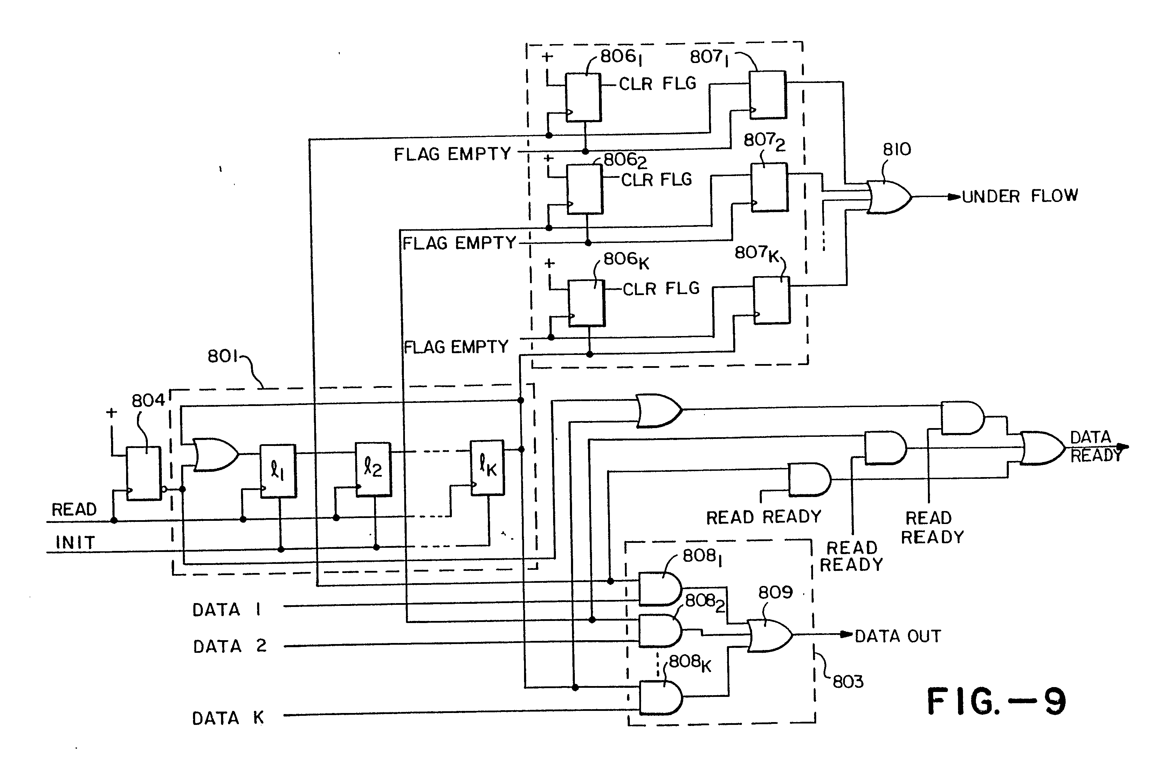

Fig. 9 illustrates a logic diagram of a preferred implementation of the output control means 103 for selecting the appropriate output from one of the arrays as the out of the FIFO memory. The output control means comprises a ring counter 801, a latch 806 coupled to the counter 801 for generating the CLRFLG signal which clears a corresponding flag upon the removal of data from an array. In the preferred implementation, the latch 806 shown in Fig. 6 is the same latch 806 as shown in Fig. 5.

The counter 801 is coupled to an output driver 803 for gating out the output of one of the array as the output of the FIFO memory 100. The ring counter 801 comprises k latches 801, where k corresponds to the number of arrays in the FIFO memory 100. The latches 801 are reset to zero at initialization. After initialization, the first latch 801a will be set to "high" by the first read operation. Each read operation causes a "high" signal to ripple in position around in the counter 801. The output of the counter 801 enables the output from an array to the data-out terminal of gate 809. The output of counter 801 also clocks a latch 806, the output of which is used to clear the last flag of the array being read.

As discussed previously in connection with Fig. 5, when a memory array is empty, its $\overline{Q_n}$ signal (also called "flag empty") will be "high". The "high" $\overline{Q_n}$ signal resets a corresponding latch 806. The output of counter 801 is also used to clock a corresponding one of latches 807 the input to latches 807 is a "flag empty" signal. When a latch 801 is "high", an "underflow" signal will be generated from gate 810. The outputs of a counter 801 are also used to produce the "data ready" signal during a read operation by examining the "read ready" signal from next to be read FIFO memory as shown from Fig. 5.

The output control means 103, thus sequentially selects output from one of the arrays 101 as output of the FIFO memory 100 for each of successive output operations. The selection is performed in the same predetermined order as the input control means 102. For example, if the predetermined order of the input control means 102 is array 2, array 3, array 1, array 2, ..., the sequence of arrays selected by the output control means will also be array 2, array 3, array 1, array 2..., and so on.

Fig. 10 illustrates an optional input interface 900 of the FIFO memory 100 for converting serial input data into parallel output data. The interface 900 comprises a shift register 901 for receiving serial data input. The shift register 901 is clocked with a "serial" clock every time serial data bit is input. Counter 902, being clocked by same "serial clock" signal, keeps track of the number of bits already entered into the shift register 901. When a predetermined number of serial data bits has entered the shift register 901, the counter 902 will load the output of the shift register into latches 903. The input interface 900 can also accept parallel data directly into latches 903 if a "parallel clock" signal is applied.

Fig. 10 illustrates an optional output interface for converting parallel output data from an array to serial output data of the FIFO memory 100. The m-bit parallel data enters a m-bit divide-by-m counter. the content of the parallel-to-serial shift register 1001 is output by a serial-out-clock.

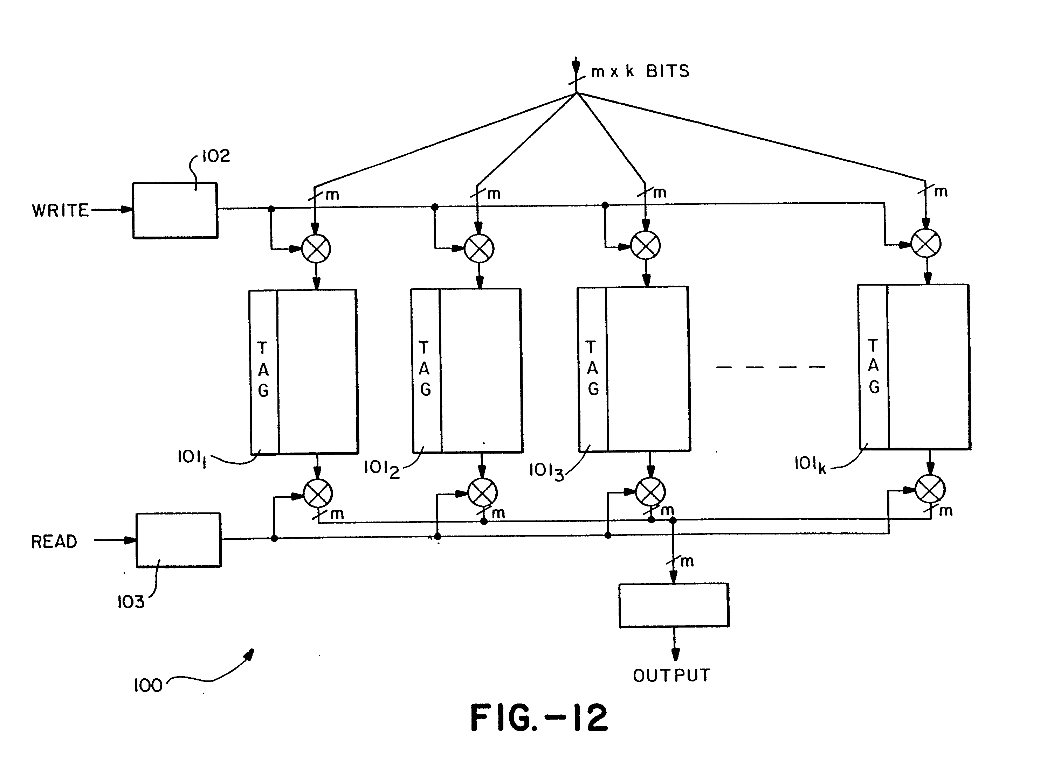

Fig. 12 illustrates a configuration wherein the FIFO memory 100 are being used as a bus funnel. In the configuration of Fig. 12, the input control means 102 is implemented so that data from each input operation is stored in parallel in all the arrays. However, The output control means 103 is implemented so that output of the FIFO memory 100 is taken, at each output operation, from one of the arrays based upon a predetermined logic function.

Typically, the logic function is implemented so that the arrays are output sequentially, as provided by the circuit of Fig. 9. By way example, assume that the FIFO memory 100 of Fig. 12 has four arrays each with eight bits. At each input operation, thirty two bits of input data is simultaneously written into all four arrays. At each output operation, however, only the output of one array is taken.

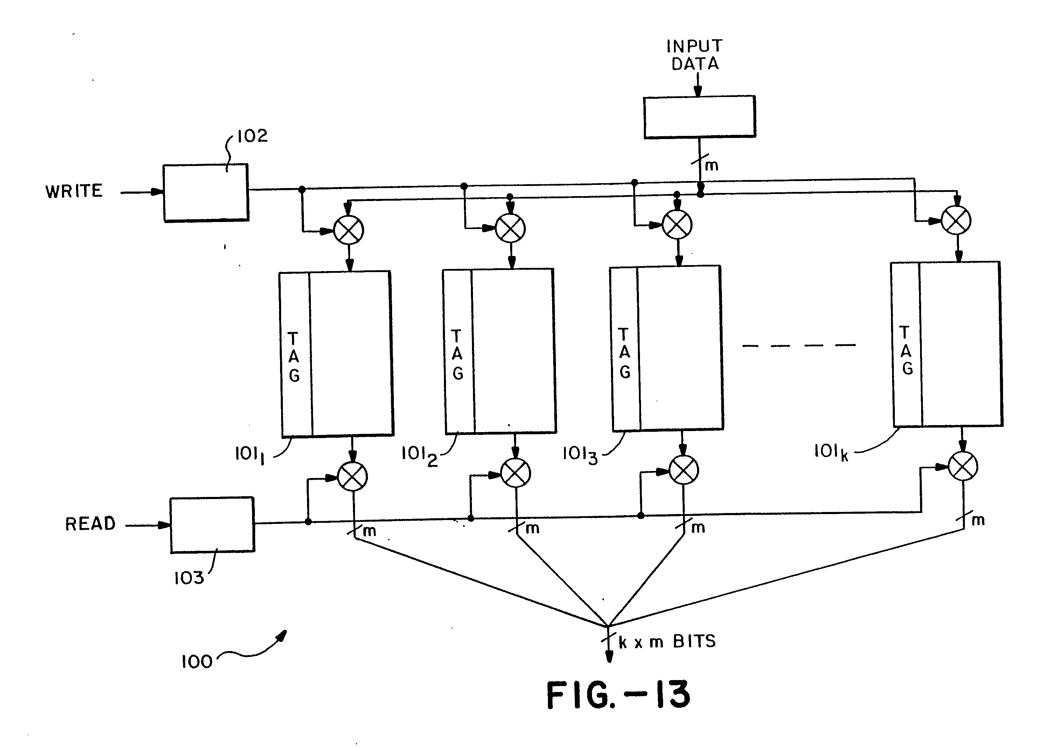

Fig. 13 illustrates a configuration wherein the FIFO memory 100 are being used as a bus expander. In the configuration of Fig. 13, the output control means 103 is implemented so that data in the FIFO memory 100 is output in parallel. However, the input controlled means is implemented so that input to the FIFO memory 100 is stored, at each input operation, in one of the arrays based upon a predetermined logic function.

Typically, the logic function is implemented so that the arrays receive input data sequentially, as provided by the circuit of Fig. 8. By way of example, assume that the FIFO memory 100 of Fig. 13 has four arrays each with eight bits. Each input operation only has eight bits of data, and is input into one of the arrays, At each output operation, thirty two bits will be simultaneously taken from the FIFO memory 100.

While the invention has been particularly shown and described with reference to the referred embodiment, it would be understood by those skilled in the art that changes in form in details could be made therein without departing from the spirit of the invention.

## Claims

1. A first-in, first-out memory, comprising:

(a) at least two arrays of ripple-through memory each having an input and an output;

(b) input control means coupled to said arrays of memory for enabling input to each of the arrays based upon a first logic function; and

(c) output control means coupled to said arrays of memory for enabling output from each of the arrays based upon a second logic function.

2. A first-in, first-out memory as in claim 1, wherein the input of the arrays are connected in common, wherein the output of the arrays are connected in common, wherein said input control means sequentially selects in accordance with a predetermined order at each input operation, one of said arrays to store an input data, and wherein said output control means sequentially selects in accordance with said predetermined order at each output operation, output from one of said arrays as the output of the first-in, first-out memory.

3. A first-in, first-out memory as in claim 2 wherein said input control means comprises a first sequential state machine having N states, N being the number of arrays in the first-in, first-out memory, each of said N states enabling a corresponding one of said arrays to store input data.

4. A first-in, first-out memory as in claim 3 wherein said first sequential state machine is a binary ring counter.

5. A first-in, first-out memory as in claim 2 wherein said output control means comprises a second sequential state machine having N states, N being the number of arrays in the first-in, first-out memory, each of said N states enabling data output from a corresponding one of said arrays.

6. A first-in, first-out memory as in claim 5 wherein said second sequential state machine is a binary ring counter.

7. A first-in, first-out memory as in claim 1, wherein said input control means selects a subset of the arrays to receive data input in parallel, and wherein said output control means sequentially selects in accordance with a predetermined order at each output operation, output from one of said arrays as the output of the first-in, first-out memory.

8. A first-in, first-out memory as in claim 7 wherein said output control means comprises a sequential state machine having N states, N being the number of arrays in the first-in, first-out memory, each of said N states enabling data output from a corresponding one of said arrays.

9. A first-in, first-out memory as in claim 8 wherein said sequential state machine is a binary ring counter.

10. The first-in, first-out memory as in claim 7, wherein the input control means selects all the arrays to simultaneously receive input data.

11. A first-in, first-out memory as in claim 1, wherein said output control means selects output from a subset of the arrays to provide a parallel output of the selected arrays, and wherein said input control means sequentially selects in accordance with a predetermined order at each input operation, one of said arrays to store an input data.

12. A first-in, first-out memory as in claim 11, wherein said input control means comprises a sequential state machine having N states, N being the number of arrays in the first-in, first-out memory, each of said N states enabling a corresponding one of said arrays to store input data.

13. A first-in, first-out memory as in claim 12 wherein said sequential state machine is a binary ring counter.

14. The first-in, first-out memory as in claim 11, wherein the output control means output data from all the arrays simultaneously.

15. A first-in, first-out memory as in claim 1, wherein each of said arrays of memory comprising:

(a) more than one row of memory cells, including a top row wherein input data is received into the array and a bottom row wherefrom data of the array is output;

(b) ripple control means coupled to the rows of memory cells for enabling data into respective rows of memory cells and for controlling rippling of data from the top row to a vacant row closest to the bottom row.

16. A first-in, first-out memory as in claim 15, wherein said ripple control means operates asynchronously.

17. A first-in, first-out memory as in claim 15, wherein said ripple control means comprises a plurality of latches serially linked, each latch being coupled to one row of the memory cells.

18. A first-in, first-out memory as in claim 1, including means coupled to the arrays for converting serial input data into parallel input data.

19. A first-in, first-out memory as in claim 1, including means coupled to the arrays for converting parallel data out of the array into serial output data of the first-in, first-out memory.

FIG. – 1

FIG.-2

FIG. -3

FIG. -4

FIG.-5

FIG.-6

INPUT DATA

OUTPUT

WRITE

READ

T A G

T A G

T A G

T A G

$101_k$

$101_3$

$101_2$

$101_1$

102

103

100

m

m

FIG.-7

FIG. -8

EP 0 353 942 A2

FIG.—9

EP 0 353 942 A2

SHIFT REGISTER

901

903

903

903

900

SERIAL DATA

SERIAL CLOCK

PARALLEL DATA

PARALLEL CLOCK

COUNTER

902

**FIG.—10**

1001

PARALLEL TO SERIAL SHIFT REGISTER

DATA OUT

m

SERIAL DATA OUT

DIVIDE BY m COUNTER

1002

SERIAL CLK

**FIG.—11**

m x k BITS

WRITE → 102

TAG   $101_1$
TAG   $101_2$
TAG   $101_3$
TAG   $101_k$

READ → 103

100

OUTPUT

FIG.-12

FIG.-13

EP 0 353 942 A2